# EUROPÄISCHE PATENTSCHRIFT

(11) **EP 2 629 340 B1**
(45) Veröffentlichungstag und Bekanntmachung des Hinweises auf die Patenterteilung: **07.04.2021**
(21) Anmeldenummer: 13155452.9
(22) Anmeldetag: 15.02.2013
(51) Int. Cl.: H01L 31/107, H01L 27/144

(54) **Halbleiterstruktur für einen auf dem Lawineneffekt beruhenden Strahlungsdetektor sowie Strahlungsdetektor**
Semiconductor structure for a radiation detector based on the avalanche effect and radiation detector
Structure semi-conductrice pour un détecteur de rayonnement basé sur l'effect d'avalanche ainsi que le détecteur rayonnement

(30) Priorität: 15.02.2012 DE 102012101224; 26.04.2012 DE 102012103699
(43) Veröffentlichungstag der Anmeldung: 21.08.2013
(73) Patentinhaber: Pierschel, Michael, 12621 Berlin (DE)
(72) Erfinder: Pierschel, Michael, 12621 Berlin (DE)
(74) Vertreter: Bittner, Thomas L.

(56) Entgegenhaltungen:
- WO-A1-2009/106032
- DE-B3-102007 037 020
- DE-B3-102009 049 793
- US-A1- 2010 148 040
- US-A1- 2010 271 108

## Beschreibung

Die Erfindung betrifft Technologien auf dem Gebiet der Halbleiterdetektoren, insbesondere der Avalanche-Fototransistoren.

### Hintergrund der Erfindung

Halbleiterdetektoren mit einer Signalverstärkung vermittels des Avalanche-Effektes werden häufig in Strahlungsempfängern für den Einzelphotonennachweis eingesetzt.

Die heute gebräuchlichen Konstruktionen erfordern einen Mechanismus, um die Feldstärke einerseits zur Einzelphotonendetektion über der Durchbruchfeldstärke zu halten, der sogenannte Geiger-Mode. Andererseits soll die Möglichkeit bestehen, nach der Detektion den Durchbruch rückgängig zu machen um schnell nachfolgende weitere Photonen detektieren zu können, das sogenannte "quenching".

Dabei existieren passive Strategien mit außerhalb des Halbleiters befindlichen Widerständen oder Halbleiterschaltungen und aktive im Halbleiter integrierte Varianten, die alle verschiedene Vor- und Nachteile aufweisen.

Seit einigen Jahren ist man bemüht, dieses Löschen("quenching") monolithisch zu integrieren. Das hat Vorteile sowohl für den sogenannten Füllfaktor, der die Ausnutzung der zur Strahlung weisenden Halbleiterfläche des Detektors beschreibt als auch zeitliche Vorteile wobei Totzeiten verringert werden, die nicht zum Detektieren genutzt werden können.

Eine dieser Lösungen stellt eine Möglichkeit dar, den Avalnche-Effekt und das "quenching" in einer monolithischen Struktur zu vereinen. Der Hauptnachteil dieser Lösung besteht darin, dass zur sicheren Funktion und zum Auffinden eines geeigneten Arbeitspunktes recht niederohmige Halbleiterschichten verwendet werden müssen. Außerdem ist die präzise Abstimmung von geometrischen Maßen und der Schichtdicke des Halbleitersubstrates erforderlich, da die mit der Niederohmigkeit verbundenen Funktionsbegrenzungen hier ein recht enges technologisches Fenster setzen. Das führt bei den typischen unvermeidbaren Schwankungen der Epitaxieschichtdicke Mitte-zu-Rand eines Wafers zu erheblichen Ausbeuteverlusten. Außerdem folgt direkt aus dem Fakt der Verwendung des niederohmigen Substratmaterials eine Funktionsbegrenzung auf recht kleine Pixelgeometrien. Das liegt im Wesentlichen daran, dass bei niederohmigen Substraten nur kleine Schichtdicken verarmt werden können und dann recht schnell die Durchbruchfeldstärken erreicht werden. Die damit direkt verbundenen großen Kapazitäten der 'floatenden' Strukturen begrenzen den für die Funktion erforderlichen Potentialhub stark. Das erschwert das Auffinden eines geeigneten Arbeitspunktes solcher Strukturen.

Außerdem wird durch die Begrenzung auf sehr kleine Pixel und deren für eine gute Quantenausbeute erforderlichen Dichte das sogenannte *"afterpulsing"* zu einem großen Problem. In jedem Mikroplasma eines Avalanche-Prozesses entstehen spontan auf Grund der stark energiebeladenen bewegten Ladungsträger einzelne strahlende Photonen. Diese Photonen können in alle Raumrichtungen innerhalb des Halbleiterkristalls strahlen. Das Spektrum dieser Strahlung ist so beschaffen, dass diese einzelnen Photonen im Mittel etwa 7 Mikrometer bis 8 Mikrometer weit strahlen können, bevor sie im Kristall absorbiert werden. Sind mit den niederohmigen Substraten nur Strukturen bis ungefähr 4 Mikrometer Pixelgeometrie realisierbar und legt man die Lückenbereiche zwischen zwei Pixeln auch recht klein aus, um eine gute Quantenausbeute zu erreichen, dann wird das Triggern direkt benachbarter Pixel zu einem Hauptproblem solcher Strukturen, da praktisch ständig derartige Phänomene die eigentlichen Messungen stören. Werden die Lückenbereiche vergrößert, dann sinkt die Quantenausbeute dramatisch. Dieses Designdilemma ist direkt verbunden mit der Verwendung der niederohmigen Halbleiterschichten.

Das Dokument DE 690 11 809 T2 offenbart eine Halbleiteranordnung mit einem Halbleiterkörper mit einem ersten Anordnungsbereich mit einem ersten Leitfähigkeitstyp, der mit einem zweiten Anordnungsbereich mit einem zweiten, zum ersten entgegengesetzten Leitfähigkeitstyp, der neben einer der Hauptflächen des Halbleiterkörpers bereitgestellt ist, einen ersten pn-Übergang bildet, der in mindestens einer Betriebsart der Anordnung sperr-vorgespannt ist. Es ist ein offener weiterer Bereich mit dem zweiten Leitfähigkeitstyp vorgesehen, der innerhalb des ersten Anordnungsbereiches und in entfernter Anordnung von den Hauptflächen des Halbleiterkörpers und beabstandet vom zweiten Anordnungsbereich bereitgestellt ist, so dass bei einer Betriebsart der Anordnung das Verarmungsgebiet des ersten pn-Übergangs den offenen weiteren Bereich erreicht, bevor der erste pn-Übergang durchschlägt. Der weitere Bereich bildet einen weiteren pn-Übergang mit einem hoch dotierten Trennbereich mit einem ersten Leitfähigkeitstyp, der innerhalb des ersten Anordnungsbereiches zwischen dem offenen weiteren Bereich und dem zweiten Anordnungsbereich und vom zweiten Anordnungsbereich beabstandet bereitgestellt ist.

Aus dem Dokument DE 697 21 366 T2 sind eine Diode sowie ein Stromrichterschaltungsapparat bekannt. Die Diode ist gebildet mit einer ersten Halbleiterschicht eines ersten Leitungstyps, einer in der ersten Halbleiterschicht vorgesehenen zweiten Halbleiterschicht eines zweiten Leitungstyps, einer mit der ersten Halbleiterschicht elektrisch verbundenen ersten Hauptelektrode sowie einer zweiten Hauptelektrode, welche die zweite Halbleiterschicht in einem Kontaktbereich innerhalb eines Randteils eines Übergangsbereichs zwischen der ersten und der zweiten Halbleiterschicht kontaktiert, wobei der Randteil am Rand des zweiten Halbleiterbereichs liegt. Der kürzeste seitliche Abstand zwischen dem Kontaktbereich und dem Randteil des Übergangs ist nicht kürzer als die Diffusionslänge von Minoritätsladungsträgern in der ersten Halbleiterschicht.

Das Dokument DE 10 2009 049 793 B3 offenbart einen Halbleiter-Photodetektor mit einem Halbleitersubstrat, einer oberen Dotierungszone, die einem ersten Dotierungstyp entsprechend dotiert ist und sich in dem Halbleitersubstrat an einer Oberseite lateral erstreckt und einer unteren Dotierungszone, die einem zweiten Dotierungstyp entsprechend dotiert ist und der oberen Dotierungszone zum Ausbilden von Avalanche-Bereichen zugeordnet ist. Die untere Dotierungszone erstreckt sich in dem Halbleitersubstrat der oberen Diodendotierungszone gegenüberliegend lateral und ist unterbrochen ausgeführt, indem zumindest ein Zwischenbereich gebildet ist. Ein Löschwiderstandsbereich ist in dem Halbleitersubstrat zwischen der unteren Dotierungszone und einer rückseitig an dem Halbleitersubstrat gebildeten Kontaktierungsschicht gebildet. Eine dem ersten Dotierungstyp entsprechend dotierte erste zusätzliche Dotierungszone ist in dem Halbleitersubstrat im Bereich zwischen der unteren Dotierungszone und der Kontaktierungsschicht angeordnet. Sie erstreckt sich unterhalb des zumindest einen Zwischenbereiches und bis in den Bereich unterhalb der unteren Dotierungszone hinein lateral und ist im Bereich unterhalb der unteren Dotierungszone unterbrochen. Eine dem zweiten Dotierungstyp entsprechend dotierte zweite zusätzliche Dotierungszone ist in dem Halbleitersubstrat im Bereich zwischen der unteren Dotierungszone und der ersten zusätzlichen Dotierungszone angeordnet. Sie erstreckt sich unterhalb des zumindest einen Zwischenbereiches lateral und bildet eine Potentialbarriere zwischen der oberen Dotierungszone und der ersten zusätzlichen Dotierungszone.

### Zusammenfassung der Erfindung

Aufgabe der Erfindung ist es, verbesserte Technologien für eine Halbleiterstruktur für einen Strahlungsdetektor sowie einen hierauf basierenden Strahlungsdetektor anzugeben, welche die Nachteile des Standes der Technik vermeiden. Insbesondere sollen die Fertigung größerer Pixelstrukturen bei dem Strahlungsdetektor mit einer besseren Quantenausbeute sowie die Minderung des sogenannten *"afterpulsing"* über größere Lückenbereiche ermöglicht sein. Auch soll die Herstellung von Arbeitspunkt und Ausbeute mit größerer Präzision unterstützt werden.

Diese Aufgabe wird erfindungsgemäß durch eine Halbleiterstruktur für einen Strahlungsdetektor nach dem unabhängigen Anspruch 1 gelöst. Weiterhin ist ein Strahlungsdetektor nach dem abhängigen Anspruch 12 vorgesehen. Vorteilhafte Ausgestaltungen der Erfindung sind Gegenstand von abhängigen Unteransprüchen.

Es ist eine Halbleiterstruktur für einen Strahlungsdetektor mit einem Substrat aus einem Halbleitermaterial von einem ersten Leitfähigkeitstyp sowie einem hierauf mit einer Halbleiterschicht gebildeten Halbleitersubstrat vorgesehen, wobei die Halbleiterschicht im Vergleich zum Substrat höherohmig ausgeführt ist. Auch die Halbleiterschicht ist vom ersten Leitfähigkeitstyp. Das Halbleitermaterial der Halbleiterschicht ist mit einer Dotierungskonzentration elektrisch dotiert. Es kann vorgesehen sein, dass das Halbleitersubstrat im Vergleich zum Substrat eine im Wesentlichen gleiche elektrische Leitfähigkeit aufweist. In dem Halbleitersubstrat sind Dotierungsgebiete gebildet, die hierin vergraben und isoliert voneinander gebildet sind. Die Dotierungsgebiete weisen einen zweiten Leitfähigkeitstyp auf, der entgegengesetzt zum ersten Leitfähigkeitstyp ist. Die Dotierungsgebiete sind mit einer Dotierungskonzentration elektrisch dotiert, die größer als die Dotierungskonzentration in dem Halbleitersubstrat ist. In dem Halbleitersubstrat ist zumindest ein weiteres Dotierungsgebiet vorgesehen, welches ebenfalls hierin vergraben ist. Das zumindest eine weitere Dotierungsgebiet ist vom ersten Leitfähigkeitstyp und einem oder mehreren der Dotierungsgebiete zugeordnet. Weiterhin ist das zumindest eine weitere Dotierungsgebiet mit einer Dotierungskonzentration elektrisch dotiert, die größer als die Dotierungskonzentration in dem Halbleitersubstrat ist. Schließlich verfügt die Halbleiterstruktur über eine Deckschicht, die auf dem Halbleitersubstrat angeordnet und vom zweiten Leitfähigkeitstyp ist.

Weiterhin ist ein Strahlungsdetektor, insbesondere Avalanche-Detektor wie Avanlanche-Fototransistor, mit einer solchen Halbleiterstruktur vorgesehen.

Bei der Verwendung der Halbleiterstruktur im Strahlungsdetektor wird diese stets in Sperrrichtung betrieben.

Bei der vorgeschlagenen Halbleiterstruktur sind die Dotierungsgebiete in dem auf dem Substrat gebildeten Halbleitersubstrat vergraben, was bedeutet, dass sie einen umlaufenden Abstand zu den Rändern des Halbleitersubstrats aufweisen. Sie sind isoliert oder getrennt voneinander gebildet. Vorzugsweise ist mit den Dotierungsgebieten eine sich in einer Ebene in dem Halbleitersubstrat erstreckende, flächige Anordnung von Dotierungszonen gebildet. Auf diese Weise ist eine sich in der Fläche erstreckende Pixelanordnung in der Halbleiterstruktur herstellbar. Die flächige Anordnung der Dotierungsgebiete erstreckt sich in der Fläche des Halbleitersubstrats.

Zusätzlich ist nun zumindest ein weiteres Dotierungsgebiet, welches sich seinerseits vorzugsweise ebenfalls in der Fläche des Halbleitersubstrats erstreckt, vorgesehen und einem oder mehreren der Dotierungsgebiete zugeordnet, was vorzugsweise bedeutet, dass in Draufsicht auf die Fläche, in welcher sich das Halbleitersubstrat erstreckt, eine wenigstens teilweise flächige Überlappung des mindestens einen weiteren Dotierungsgebietes mit dem einen oder den mehreren zugeordneten Dotierungsgebieten gebildet ist. Bei der Nutzung der Halbleiterstruktur in dem Strahlungsdetektor bedeutet dies eine flächige Überlappung in Blickrichtung auf den photoaktiven Bereich (Sensorfläche) des Detektors.

Das Halbleitersubstrat weist eine elektrische Dotierungskonzentration auf, mit der eine schwache elektrische Dotierung gebildet ist, derart, dass das Halbleitersubstrat im Vergleich zu dem Substrat hochohmig ist, wohingegen das Substrat niederohmig ausgebildet ist. Demgegenüber weisen die Dotierungsgebiete eine Dotierungskonzentration auf, die ausreichend ist, ein Verarmen an Ladungsträgern im Betrieb zu unterbinden. Die Dotierungsgebiete verarmen also im Betrieb nicht an Ladungsträgern.

Im Bereich des Halbleitersubstrates zwischen den Dotierungsgebieten und der Deckschicht ist ein Avalanche-Bereich gebildet, also ein Bereich hoher elektrischer Feldstärke (Hochfeld), in welchem beim Einsatz der Halbleiterstruktur im Strahlungsdetektor aufgrund von Stößen eine Vervielfältigung von freien Ladungsträgern stattfindet (Avalanche-Effekt). Im Bereich zwischen den Dotierungsgebieten und dem Substrat ist im Halbleitersubstrat der Lösch-Bereich hergestellt.

Die auf dem Halbleitersubstrat angeordnete Deckschicht ist mit einem Leitfähigkeitstyp hergestellt, der entgegengesetzt zum Leitfähigkeitstyp des darunterliegenden Halbleitersubstrats ist. Auf diese Weise ist zwischen der Deckschicht und dem Halbleitersubstrat ein pn-Übergang gebildet, der bei Nutzung der Halbleiterstruktur im Strahlungsdetektor im Betrieb als Topdiode wirkt.

Im Vergleich zum Stand der Technik ist hier vorgeschlagen, anstelle eines niederohmigen ein hochohmiges Halbleitersubstrat einzusetzen. Zur Ausbildung der Hochohmigkeit kann das Halbleitersubstrat (hochohmiges Halbleitersubstrat) einen spezifischen Widerstand (spezifischer Volumenwiderstand) von wenigstens 500 Ohm cm aufweisen. Eine obere Grenze der Hochohmigkeit kann der Übergang zur elektrischen Eigenleitung des Substratmaterials bilden.

Darüber hinaus sind zusätzlich zu den üblichen Dotierungsgebieten ein oder mehrere weitere Dotierungsgebiete in dem Halbleitersubstrat vorgesehen. Sie bilden zusätzliche Dotierungszonen im Halbleitersubstrat und ermöglichen die Bereitstellung von Funktionen des ehemals niederohmigen Halbleitersubstrats. Insbesondere wird eine präzise Einstellung des Arbeitspunktes unterstützt. Mithilfe des zumindest einen weiteren Dotierungsgebietes, welches einem oder mehreren der Dotierungsgebiete zugeordnet ist, erfolgt eine Entkopplung von dem in der Gesamthalbleiterstruktur erforderlichen Aufbau von Ladungsträger-Verarmungszonen und dem Einstellen der für den Betrieb erforderlichen Barrierehöhen. Das Vorsehen der einen oder der mehreren weiteren Dotierungsgebiete stellt einen zusätzlichen Freiheitsgrad beim Design der Halbleiterstruktur bereit, sodass hier auch Arbeitspunkte eingestellt werden können, die zum Beispiel Schichtdickeschwankungen von verwendeten Epitaxiesubstraten ausgleichen können.

Eine bevorzugte Weiterbildung sieht vor, dass das zumindest eine weitere Dotierungsgebiet auf einer der Deckschicht zugewandten Seite und / oder einer dem Substrat zugewandten Seite der Dotierungsgebiete gebildet ist. Im Fall der als flächige Anordnung gebildeten Dotierungsgebiete ermöglicht dies ein Anordnen des zumindest einen weiteren Dotierungsgebietes unterhalb- und / oder oberhalb der flächigen Anordnung. Auch kann vorgesehen sein, dass sich das zumindest eine weitere Dotierungsgebiet in der flächigen Anordnung der Dotierungsgebiete in dem Halbleitersubstrat in einem oder mehreren Zwischenbereichen zwischen benachbarten Dotierungsgebieten erstreckt. Bei der Ausbildung des zumindest einen weiteren Dotierungsgebietes auf der der Deckschicht zugewandten Seite der Dotierungsgebiete ist das zumindest eine weitere Dotierungsgebiet vorzugsweise in einem Bereich des Halbleitersubstrates zwischen der Deckschicht und den Dotierungsgebieten angeordnet. Beim Vorsehen des zumindest einen weiteren Dotierungsgebietes auf der dem Substrat zugewandten Seite der Dotierungsgebiete ist das zumindest eine weitere Dotierungsgebiet vorzugsweise in einem Bereich des Halbleitersubstrats zwischen den Dotierungsgebieten und dem Substrat angeordnet.

Bei einer zweckmäßigen Ausgestaltung kann vorgesehen sein, dass das zumindest eine weitere Dotierungsgebiet in Berührungskontakt mit dem oder den zugeordneten Dotierungsgebieten gebildet ist. Der Berührungskontakt kann flächig ausgebildet sein. Es kann vorgesehen sein, dass sich das zumindest eine weitere Dotierungsgebiet in einem Bereich mit dem zugeordneten Dotierungsgebiet überlappt und darüber hinaus bis in einen Zwischenbereich zwischen den Dotierungsgebieten gebildet ist.

Eine vorteilhafte Ausführungsform sieht vor, dass das zumindest eine weitere Dotierungsgebiet in einem Überlappungsbereich, in welchem das zumindest eine weitere Dotierungsgebiet überlappend mit dem oder den zugeordneten Dotierungsgebieten gebildet ist, eine Schichtdicke aufweist, die von einer Schichtdicke des zumindest einen weiteren Dotierungsgebietes außerhalb des Überlappungsbereiches verschieden ist. Bei der Verwendung der Halbleiterstruktur in dem Strahlungsdetektor ergibt sich die Überlappung in Blickrichtung auf die photoaktive Fläche des Strahlungsdetektors, die mithilfe der Halbleiterstruktur gebildet ist. Die Schichtdickenangaben beziehen sich auf eine Erstreckung quer zur flächigen Erstreckung der Dotierungsgebiete.

Bevorzugt sieht eine Fortbildung vor, dass für das zumindest eine weitere Dotierungsgebiet die Schichtdicke im Überlappungsbereich geringer als außerhalb des Überlappungsbereiches ist.

Bei einer vorteilhaften Ausgestaltung kann vorgesehen sein, dass das zumindest eine weitere Dotierungsgebiet als ein zusammenhängendes Dotierungsgebiet für mehrere der Dotierungsgebiete gebildet ist. In einer Ausgestaltung ist das zumindest eine weitere Dotierungsgebiet als eine durchgehende Schicht hergestellt. Diese oder andere Ausführungsformen können wahlweise ohne die Verwendung einer Maskierung beim Abscheiden des Halbleitermaterials in der Herstellung gebildet werden.

Eine Weiterbildung kann vorsehen, dass das zumindest eine weitere Dotierungsgebiet mit einem der Dotierungsgebiete flächig überlappt und um die Überlappungsfläche ein im Wesentlichen umlaufend gleichbleibender Überstand gebildet ist, in welchem das zumindest eine weitere Dotierungsgebiet gegenüber dem einen der Dotierungsgebiete seitlich übersteht. In Blickrichtung auf die flächige Anordnung von Dotierungsgebieten bedeutet dies, dass das zumindest eine weitere Dotierungsgebiet das zugeordnete Dotierungsgebiet vollständig überdeckt und umlaufend in gleichem Umfang übersteht.

Eine bevorzugte Weiterbildung sieht vor, dass das zumindest eine weitere Dotierungsgebiet zumindest abschnittsweise mit gleicher Schichtdicke wie das oder die zugeordneten Dotierungsgebiete gebildet ist. Die Schichtdickenangabe bezieht sich wieder auf eine Erstreckung quer zur flächigen Anordnung der Dotierungsgebiete.

Bei einer zweckmäßigen Ausgestaltung kann vorgesehen sein, dass das in einem Bereich des Halbleitersubstrates zwischen der Deckschicht und den Dotierungsgebieten ein oder mehrere zusätzliche obere Dotierungsgebiete gebildet sind, die in dem Halbleitersubstrat den Avalanche-Bereich in seiner Ausdehnung von der Deckschicht weg hin zu den Dotierungsgebieten begrenzen. Mit dem Avalanche-Bereich ist ein Vervielfältigungsgebiet hergestellt, in welchem es nach der Absorption des einfallenden und zu detektierenden Lichtes aufgrund von Stößen zur Vervielfältigung freier Ladungsträger kommt. Dieses erfolgt in dem Bereich hoher Feldstärke (Hochfeld). Mithilfe der einen oder der mehreren zusätzlichen oberen Dotierungsgebiete ist eine individuelle Ausgestaltung des Avalanche-Bereiches ermöglicht.

Eine vorteilhafte Ausführungsform sieht vor, dass in einem Bereich des Halbleitersubstrates zwischen dem Substrat und den Dotierungsgebieten ein oder mehrere zusätzliche untere Dotierungsgebiete gebildet sind, die in dem Halbleitersubstrat den Lösch-Bereich in seiner Ausdehnung von den Dotierungsgebieten weg hin zum Substrat begrenzen. Mithilfe des Lösch-Bereiches wird der zuvor stattgefundene Avalanche-Effekt wieder gelöscht, um so schnell die Detektion nachfolgender Photonen zu ermöglichen (*"quenching"*). Mithilfe des einen oder der mehreren zusätzlichen unteren Dotierungsgebiete ist eine individuelle Ausgestaltung des Lösch-Bereiches in dem Halbleitersubstrat ermöglicht.

### Beschreibung bevorzugter Ausführungsbeispiele

Nachfolgend werden weitere Aspekte der Erfindung erläutert, insbesondere auch unter Bezugnahme auf Ausführungsformen. Es wird auf Figuren einer Zeichnung Bezug genommen. Hierbei zeigen:
- Fig. 1: eine schematische Darstellung einer Anordnung eines bekannten Halbleiterdetektors,
- Fig. 2: eine schematische Darstellung einer Halbleiterstruktur im Schnitt, wobei neben Dotierungsgebieten diesen zugeordnete weitere Dotierungsgebiete in einem Halbleitersubstrat angeordnet sind,
- Fig. 3: eine schematische Darstellung von Potentialen entlang einer Linie AA in der Halbleiterstruktur aus Fig. 2,
- Fig. 4: eine schematische Darstellung der Halbleiterstruktur in Fig. 2 im Schnitt, wobei eine Kapazität einer Dotierungszone gezeigt ist,
- Fig. 5: ein vereinfachtes Ersatzschaltbild einer Struktur eines Pixels,
- Fig. 6: eine schematische Darstellung zeitlicher Abläufe,
- Fig. 7: eine schematische Darstellung einer Halbleiterstruktur im Schnitt, wobei ein Ausführungsbeispiel für eine laterale Ausdehnung der weiteren Dotierungsgebiete gezeigt ist,
- Fig. 8: eine schematische Darstellung einer Halbleiterstruktur im Schnitt, wobei ein anderes Ausführungsbeispiel für die laterale Ausdehnung der weiteren Dotierungsgebiete gezeigt ist,
- Fig. 9: eine schematische Darstellung einer Halbleiterstruktur im Schnitt, wobei ein weiteres Ausführungsbeispiel für die laterale Ausdehnung der weiteren Dotierungsgebiete gezeigt ist,
- Fig. 10: eine schematische Darstellung einer Halbleiterstruktur im Schnitt, wobei noch ein weiteres Ausführungsbeispiel für die laterale Ausdehnung der weiteren Dotierungsgebiete gezeigt ist,
- Fig. 11: eine schematische Darstellung einer Halbleiterstruktur mit zusätzlichen oberen Dotierungsgebieten,
- Fig. 12: eine schematische Darstellung einer Halbleiterstruktur mit zusätzlichen unteren Dotierungsgebieten,
- Fig. 13: eine schematische Darstellung einer Halbleiterstruktur mit zusätzlichen oberen und unteren Dotierungsgebieten und
- Fig. 14: eine schematische Darstellung einer Halbleiterstruktur für einen Strahlungsdetektor in Verbindung mit einem passiven Löschen ("quenching").

In einem Ausführungsbeispiel wird von einem Material für ein Halbleitersubstrat vom n-Leitfähigkeitstyp ausgegangen. Die Erfindung ist aber auch ohne Einschränkungen auf Substrate vom p-Typ der Leitfähigkeit übertragbar. Die angegebenen Leitfähigkeitstypen sind in diesem Fall zyklisch zu vertauschen.

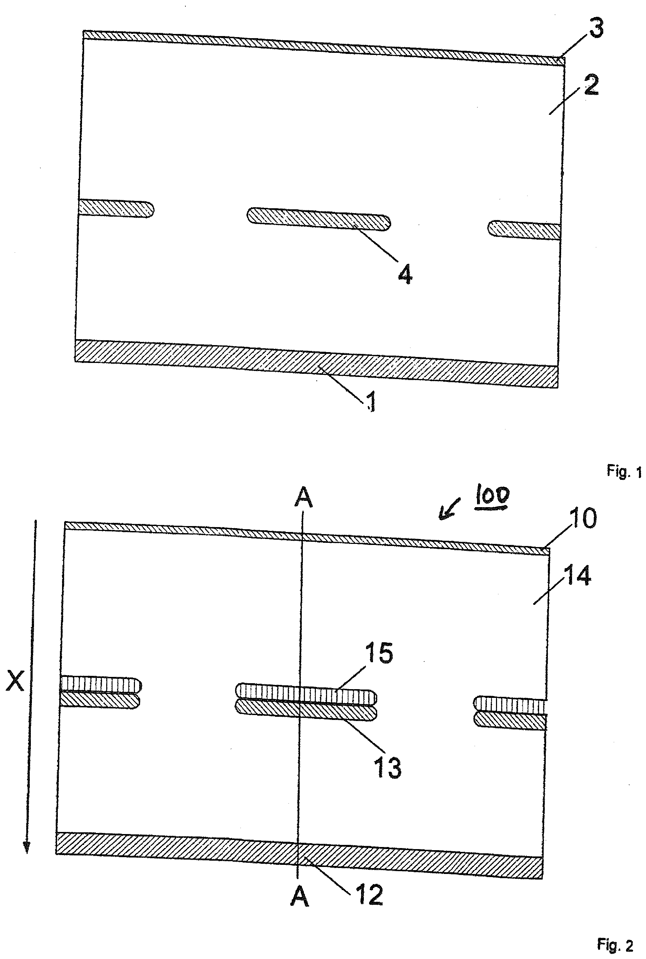

Fig. 1 zeigt eine schematische Darstellung eines bekannten Halbleiterdetektors. Auf einem sehr niederohmigen n-type Epitaxiesubstrat 1 ist ein niederohmiges p-Typ Halbleitersubstrat 2 mit einer Topdiode 3 vom n-Leitfähigkeitstyp angeordnet. Ungefähr in der Mitte dieser Anordnung befinden sich Dotierungszonen 4 vom n-Typ, die vollständig isoliert sind und 'floaten'. Dargestellt ist hier nur ein kleiner Ausschnitt mit drei der Dotierungszonen 4. Reale Bauelemente können aber tausende davon aufweisen, angeordnet als Matrix oder auch in hexagonalen Feldern. Nachteile sind hier die großen Arbeitspunktspannungen zum vollständigen Verarmen der niederohmigen Schichten und natürlich die mit dieser Niederohmigkeit verbundenen großen Kapazitäten der 'floatenden' Strukturen. Diese Kapazitäten begrenzen den für den Betrieb erforderlichen Potentialhub erheblich, so dass nur sehr kleine Pixel mit dann ausreichend kleiner Kapazität überhaupt zur Funktion gebracht werden können. Verbunden damit sind eingangs beschriebenen Nachteile bezüglich des Pixel-zu-Lückenbereich Flächenverhältnisses und damit der Quantenausbeute und natürlich das ebenfalls mit den kleinen Dimensionen verbundene und hier sehr stark auftretende 'afterpulsing' und des 'pseudoafterpulsings' auf Grund der falschen Materialwahl des Halbleitersubstrates 6. Dieses Phänomen des 'pseudoafterpulsings' in einer solchen Struktur wird am Ende der folgenden Anordnung noch einmal detailliert erläutert.
Fig. 2 zeigt eine schematische Darstellung einer Halbleiterstruktur 100 im Schnitt, wobei neben Dotierungsgebieten 13 diesen zugeordnete weitere Dotierungsgebiete 15 in einem Halbleitersubstrat 14 angeordnet sind. In der Halbleiterstruktur 100 bildet eine hochohmige, n-dotierte Halbleiterschicht das Halbleitersubstrat 14. Die Halbleiterschicht weist vorzugsweise 300 Ohmcm oder noch größere Werte auf. Zur präzisen Einstellung des Arbeitspunktes der Halbleiterstruktur 100, wenn diese in einem Strahlungsdetektor verwendet wird, dient die weitere Dotierungszone 15, die vom n-Leitfähigkeitstyp ist und somit den gleichen Leitfähigkeitstyp wie das Halbleitersubstrat 14 aufweist, aber eine deutlich höhere Dotierungskonzentration als das Halbleitersubstrat 14 besitzt.

Das Halbleitersubstrat 14 ist hier als Epitaxieschicht auf ein sehr niederohmiges Substrat 12 vom n-Leitungstyp aufgewachsen. Das Substrat 12 bildet bei dieser Ausgestaltung ein Epitaxiesubstrat. Die als floatende Bereiche ausgeführten Dotierungsbiete 13 sind vom p-Leitungstyp und verarmen im Betrieb niemals vollständig an Ladungsträgern. Das ist im Gegensatz zu den weiteren Dotierungsgebieten 15, die vollständig an Ladungsträgern verarmen können. Die Halbleiterstruktur 100 wird von einer p-leitenden Deckschicht 10 überdeckt, die zusammen mit dem benachbarten Halbleitersubstrat 14 einen pn-Übergang für eine Topdiode bildet. Zum Betrieb der Halbleiterstruktur 100 als Strahlungsdetektor wird zwischen Deckschicht 10 und Substrat 12 eine Sperrspannung angelegt.

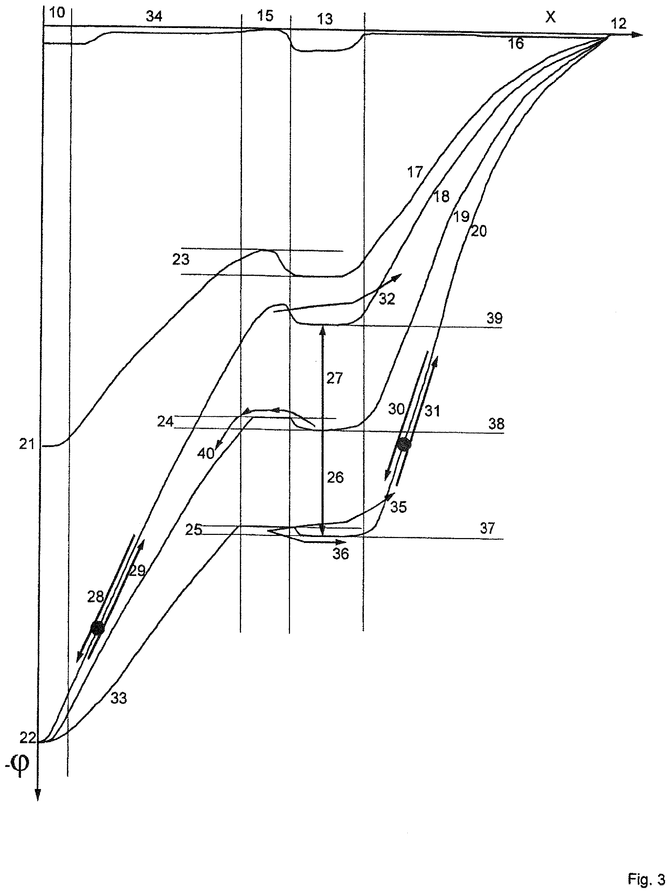

Fig. 3 zeigt eine schematische Darstellung von Potentialen entlang einer Linie AA in der Halbleiterstruktur 100 aus Fig. 2. Kurve 16 zeigt das Potential im thermodynamischen Gleichgewicht, das im Wesentlichen die statischen Diffusionspotentiale abbildet.

Darüber sind die Regionen in den verschiedenen Kristalltiefen gekennzeichnet: 10 - Deckschicht (Topdiode), die hier als Kollektor der Ladungen und Steuerelektrode dient; 15 - weiteres Dotierungsgebiet, das als Basisgebiet des Avalanche-Fototransistors bezeichnet wird; 13 das floatende nicht verarmende Dotierungsgebiet, das hier als nicht direkt an ein Potential angeschlossener Emitter für Löcherladungen dient; und 12 - die Gegenelektrode des Substrates.

Wird an die mittels der Deckschicht 10 gebildete Topdiode ein Potential 21 gegenüber dem Substrat 12 angelegt, so verändert sich der Potentialverlauf gemäß Kurve 17. Es wird im Bereich oberhalb und unterhalb des floatenden Emitters ein elektrisches Feld aufgebaut und über die mit der weiteren Dotierungszone 15 eingestellte Potentialbarriere 23 fließen Löcherladungen gegen die Topdiode ab.

Mit den für die Einzelphotonen-Detektion erforderlichen sehr kleinen Dunkelströmen fließen hier nur sehr wenige Elektronen in die eine Basisregion bildende weitere Dotierungszone 15, die auf Grund der seitlich fehlenden Barriere stets zum Substrat 12 abfließen können. Die weiteren Dotierungszone 15 bleibt also hier praktisch ladungsfrei, und die Potentialbarriere 23 stellt sich auf Grund der Fermi-Boltzmann Statistik der Löcherladungen in dem Dotierungsgebiet 13 ein, welches ein Emittergebiet für diese Löcherladungsträger bildet. Das beinhaltet natürlich auch Löcherladungen des Dunkelstromes, die in dem unteren Bereich in Richtung zum Substrat 12 hin gelegen generiert werden und die in die Dotierungszone 13 (Emittergebiet) einströmen.

Um den eigentlichen Arbeitspunkt der Struktur zu erreichen, wird das Potential der Topdiode auf den Wert 22 erhöht.

Die Kurve 18 zeigt den entsprechenden Verlauf des Potentials. Es ergibt sich, dass die elektrische Feldstärke im oberen Bereich, nahe der Deckschicht 10 (Topdiode), die für einen Avalanche-Durchbruch erforderliche Feldstärke überschreitet. Ein einzelnes Triggerereignis, zum Beispiel ein einzelnes eingestrahltes Photon, löst hier einen Lawinendurchbruch aus. Hierbei werden beide Arten von Ladungsträger generiert, also Elektronen und Löcher. Die entstehenden Löcher bewegen sich unter dem Einfluss des Feldes in Pfeilrichtung 28 bis in den Bereich der Topdiode und werden von dieser aufgenommen. Die entstehenden Elektronen bewegen sich in Pfeilrichtung 29 und werden zunächst in der weiteren Dotierungszone 15 (Basisbereich) gesammelt. Dieser Vorgang ist sehr schnell und dauert nur wenige Pikosekunden.

Die im Basisbereich befindlichen Elektronenladungen bewirken einen Abbau der dort ausgebildeten Potentialbarriere und verschieben auf Grund ihrer Anwesenheit das Potential dort in eine negative Richtung. Damit sinkt das Potential in der Dotierungszone 13 (Emittergebiet) vom Wert 39 auf den in Fig. 3 mit 38 bezeichneten Wert ab.

Zusätzlich beginnen jetzt auf Grund der abgebauten Potentialbarriere 24 Löcherladungen aus dem Bereich der Dotierungszone 13 zur Topdiode zu fließen. Dieser Prozess ist mit dem Pfeil 40 angedeutet, und der zugehörige Potentialverlauf ist in Fig. 3 mittels Kurve 19 dargestellt. Der Verlust an Löcherladungen bewirkt ein weiteres Absinken des Potentials der Emitterregion auf den Wert 37. Hierdurch verschiebt sich das Potential weiter wie in Kurve 20 angedeutet. Auch dieser Vorgang ist sehr schnell und bei kleinen Kollektorlaufzeiten sind die Ladungsträger ebenfalls im Bereich einiger Pikosekunden in der Topdiode angelangt.

Es ergibt sich, dass jetzt die im vorderen Bereich ehemals vorhandene Durchbruchfeldstärke verschwunden ist. Dieser Prozess wird als *"quenching"* (Löschen) bezeichnet und der Avalanche-Durchbruch im oberen Bereich der Halbleiterstruktur 100 ist damit beendet.

Gleichzeitig ist aber auf Grund der geometrischen Dimensionierung in dem Bereich hinter der Dotierungszone 13 (Emitterregion) eine Feldstärke entstanden, die zu einem Avalanche-Durchbruch führen kann. Das passiert aber nur dann, wenn dort auch Ladungsträger existieren, die einen solchen Durchbruch triggern. Im Dunkelfall passiert so etwas äußerst selten. Ein größerer Teil der Elektronenladungen im Basisbereich rekombiniert auf Grund der dort durchgeflossenen Löcherladungen. Die verbleibenden dort gespeicherten Anteile an Elektronen fließen jetzt zu einem Teil über die doch sehr niedrige Barriere in das Emittergebiet (Dotierungszone 13) und werden spätestens dort rekombinieren, Pfeil 36 in Fig. 3.

Ein sehr kleiner Restteil dieser Elektronenladungen fließt aber sehr langsam in dem dort vorhandenen und im Abschnürbereich betriebenen, vergrabenen MOS-Kanal seitwärts ab. Dieser Prozess kann auf Grund der Hochohmigkeit dieses Kanals einige hundert Nanosekunden oder auch Mikrosekunden dauern. In Fig. 3 ist dieser Prozess mit Pfeil 35 dargestellt. Da schon die ersten Promille dieser seitlich der Dotierungszone 13 abfließenden Restladungen in das sehr hohe elektrische Feld dort gelangen, reichen jetzt ebenfalls einige Pikosekunden, bis der dort sofort stattfindende Avalanche-Durchbruch im Bereich 30, 31, die zuvor in die Topdiode abgeflossenen Löcherladungen ersetzen und damit das Potential bis in einen Bereich 39 verschieben, so wie es die Kurve 18 zeigt.

Schon nach sehr kurzer Zeit ist also die Halbleiterstruktur 100 im vorderen Bereich (oberer Bereich unterhalb der Deckschicht 10) erneut in den Geiger-Mode geschaltet, unabhängig davon wie lange das eigentliche seitliche Abfließen der Elektronenladungen auch noch dauern möge. Dieses weitere Abfließen der Elektronenladungen ist nun nicht mehr mit einer Avalanche-Verstärkung der weiter zum Substrat 12 strömenden Elektronenladungen verbunden und der Löcherzustrom in das floatende Emittergebiet stoppt hier selbstbegrenzend genau dann, wenn im hinteren Bereich die für den Avalanche-Effekt kritische Feldstärke unterschritten wird.

Da im Falle der Einzelphotonennachweise für viele tausend Pixel die Ruhepausen zwischen zwei Einzelereignissen das gleiche Pixel betreffend auch ausreichend groß sind, ist das weitere sehr langsame Abfließen dieser Elektronenladungen auch kein größeres Arbeitspunktproblem.

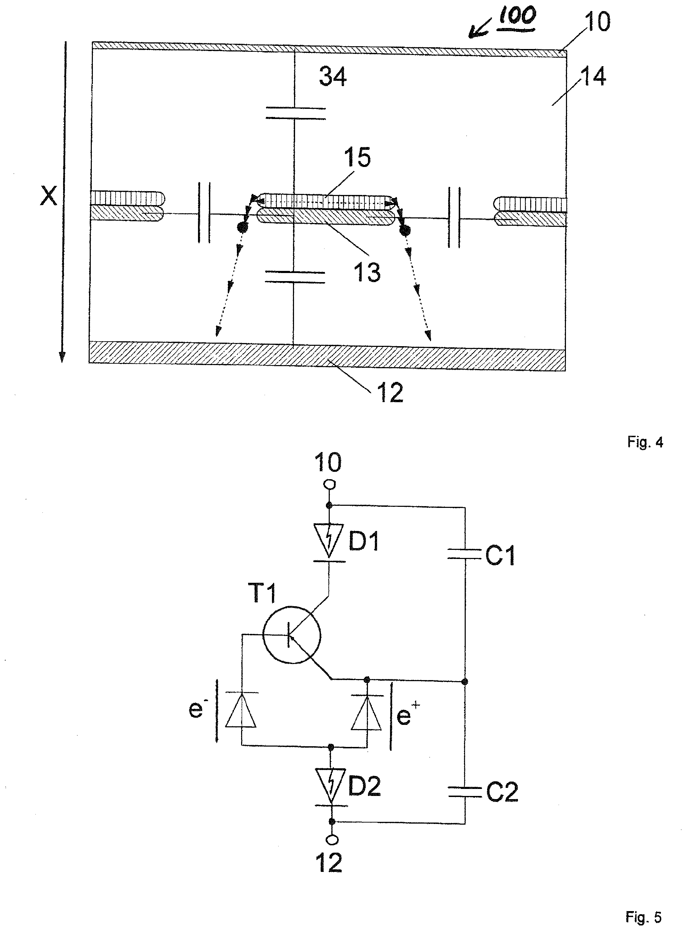

Wie groß der Potentialhub zwischen dem oberen Potential 39 und dem unteren 37 genau ist, hängt unter anderem von der Dimensionierung der weiteren Dotierungszone 15 und der hierdurch eingestellten Potentialbarriere 23 sowie der Gesamtkapazität aller vier in Fig. 4 dargestellten Teilkapazitäten der floatenden Dotierungszone 13 ab. In Fig. 4 ist außerdem noch einmal der Weg der Elektronenladungen aus der der weiteren Dotierungszone 15 (Basisregion) zum Substrat 12 dargestellt. Die ungefähre Lage der Zonen mit der höchsten Feldstärke zum Substrat 12 hin, in denen Teile der Elektronenladungen multipliziert werden, ist mittels Punkten markiert. Die hierbei entstehenden Löcherladungen fließen direkt in die Emitterregion (Dotierungszone 13) zurück und stellen damit den Arbeitspunkt zurück.

Das Ersatzschaltbild in Fig. 5 ist deshalb nur vereinfacht, da vorhandene Koppelkapazitäten zu den benachbarten Pixeln hier zur Vereinfachung der Darstellung weggelassen sind. In Fig. 5 bezeichnen D1 die Avalanche-Diode im oberen Teil der Halbleiterstruktur 100 eines Pixels bei Position 34, D2 die Avalanche-Diode im unteren Teil der Halbleiterstruktur 100 eines Pixels sowie C1 und C2 die Kapazitäten zum 'floatenden' Emitter des Bipolartransistors T1. Die gestrichelt angedeuteten Diodenstrukturen sind nicht real vorhanden und sollen hier nur andeuten, das erstens die Avalanche-Diode D2 von den aus der Basis des Transistors T1 fließenden Elektronenladungen e⁻ gespeist wird und die dort vermittels Avalanche-Multiplikation entstehenden Löcherladungen e⁺ in das Emittergebiet fließen.

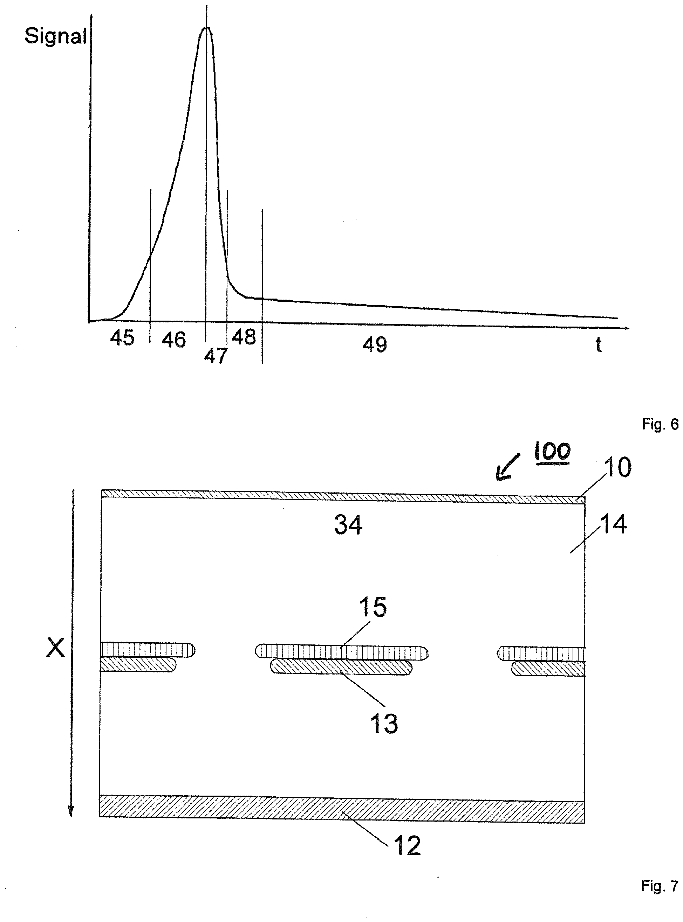

Fig. 6 zeigt eine schematische Darstellung zeitlicher Abläufe in Verbindung mit den vorangehend beschriebenen Vorgängen in der Halbleiterstruktur 100.

Im Anlaufbereich 45 wird ein einzelnes Photon in der oberen Avalanche-Diode D1 absorbiert und eine Lawinenmultiplikation beginnt. In dieser Phase werden typischerweise 25.000 bis 100.000 Ladungsträger beider Arten generiert, da die elektrische Feldstärke dort und zu diesem Zeitpunkt größer als die für den Lawinendurchbruch erforderliche Feldstärke ist. Diese Ladungsträger werden vom Feld getrennt. Die Löcherladungen fließen in die Topdiode, die Elektronenladungen in das weitere Dotierungsgebiet 15 (Basisgebiet). Das passiert innerhalb weniger Pikosekunden. Im Basisgebiet wird daraufhin das Potential der Barriere zwischen dem weiteren Dotierungsgebiet 15 und dem floatenden Dotierungsgebiet 13 (Emittergebiet) verringert, und es beginnen weitere Löcherladungen, die auf den Kapazitäten C1, C2 gespeichert sind zur mit der Deckschicht 10 gebildeten Topdiode zu fließen. Das ist in dem Gebiet 46 als Stromanstieg zu verzeichnen. Die Gesamtzahl der hier fließenden Ladungsträger hängt von der Stromverstärkung der Bipolarstruktur ab und beträgt zwischen 10 ... 100 ... 1000. Durch den starken Löcherverlust des Dotierungsgebietes 13 sinkt das Potential dieses Gebietes so weit, dass der Avalanche-Prozess in D1 zum Erliegen kommt. Außerdem wird hier ein Großteil der durch die Multiplikation generierten Elektronenladungen im Basisgebiet 15 rekombinieren. Auch dieser Prozess ist sehr schnell und bedarf nur weniger weiterer Pikosekunden.

Durch den Verlust an Elektronenladungen wird die Barriere zwischen dem weiteren Dotierungsgebiet 15 und dem Dotierungsgebiet 13 größer und der Stromfluss zur Topdiode bricht zusammen wie im Bereich 47 dargestellt. Im weiteren Dotierungsgebiet 15 (Basis) sind jetzt nur noch relativ wenige Elektronenladungen, die nur an der Seite eines Pixels abfließen können. Die ersten dort zum Substrat 12 abfließenden Elektronenladungen starten jetzt den zweiten Avalanche-Prozess in der unteren Diode D2. Auch dieser Prozess ist sehr schnell, und im Zeitraum 48 werden hierdurch die Löcherladung auf den Emitterkapazitäten C1, C2 erneuert und damit die gesamte Struktur zurück in den für Photonen empfangsbereiten Geiger-Mode der oberen Avalanche-Diode D1 gebracht. Danach, im Zeitbereich 49 sind nur noch sehr wenige Elektronen im weiteren Dotierungsgebiet 15 verblieben, die in deutlich längeren Zeiträumen, die im Mirosekundenbereich liegen können, aus diesem im Abschnürbereich betriebenen *"buried channel"* Gebiet gegen das Substrat 12 abfließen und dabei nur noch wenig oder gar nicht multipliziert werden, da mit der Rückkehr in den Geiger-Mode des oberen Bereiches 34 hier kein ausreichend hohes elektrisches Feld zur signifikanten Multiplikation der Ladungsträger mehr existiert.

Aufgrund dieses Mechanismus werden im Mittel genau so viele Löcherladungen in der Diode D2 generiert, dass das Emittergebiet in den oberen Arbeitspunkt, Kurve 18 geschaltet wird. Im Mittel sagt dabei nur aus, das es einmal mehr und einmal weniger sein können. Sind es weniger, so verschiebt sich nur der Arbeitspunkt des Potentiales geringfügig. Sind es aber mehr, so fließen die überschüssigen Ladungsträger zur Topdiode hin ab. Da sich hier aber die Barrierenhöhe als Diffusionspotential über Ladungsträgerdiffusion aus dem Dotierungsgebiet 13 zur Topdiode hin einstellt ist die verwendete Ladungsträgerart nicht austauschbar. Löcherladungen haben in Silizium eine um typisch den Faktor k=0,002 kleinere Wahrscheinlichkeit, eine Avalanche-Lawine auszulösen, als Elektronenladungen. Verwendet man hier umgekehrte Leitfähigkeiten für diese Struktur, also p-Typ Halbleiter als Epitaxieschicht und n-Typ Halblieter für den 'floatenden' Emitter, dann stellt sich die Barrierenhöhe über den Abfluss von Elektronen zur dann n-type Topdiode ein. Diese Elektronen verursachen dann mit sehr hoher Wahrscheinlichkeit einen weiteren Lawinendurchbruch, der fälschlicherweise als 'afterpulsing' imaginären strahlenden Photonen aus den Nachbarpixeln zugeschrieben wird. Wir haben es aber hier nur mit einem *"pseudo-afterpulsing"* zu tun, hervorgerufen durch diese falsche Materialwahl und auf Grund des oben beschriebenen Prozesses der Widerherstellung des Arbeitspunktes durch Elektronendiffusion über die Barriere. Daraus folgt, dass vorzugsweise der 'floatende' Emitter und die Topdiode immer vom p-Leitungstyp und die ihn umgebende hochohmige Halbleiterschicht und das weitere Dotierungsgebiet 15 n-leitend sein sollten, sofern Silizium als Grundmaterial gewählt wird.

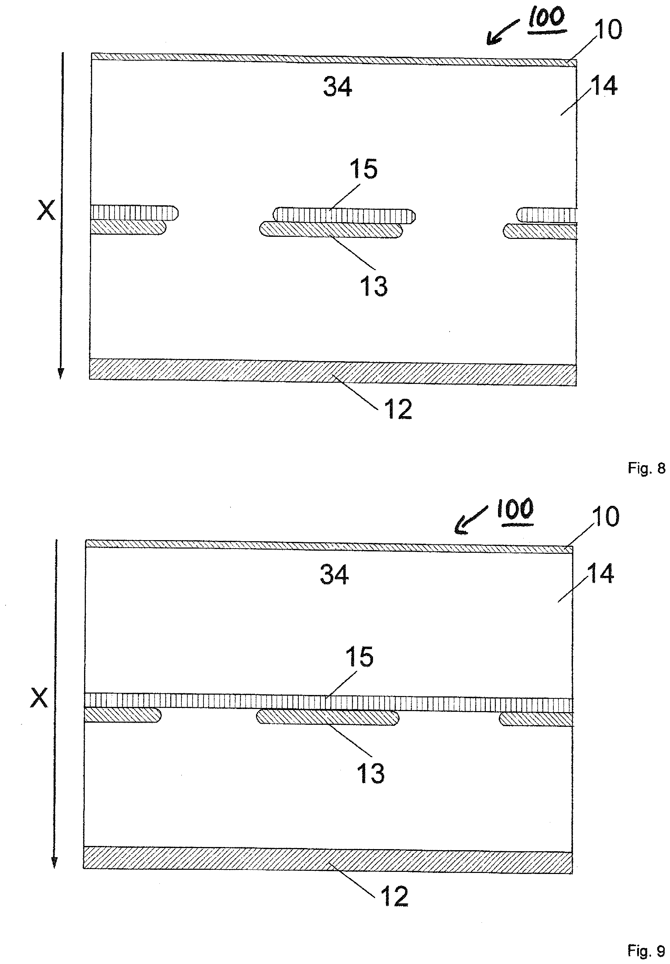

Die Fig. 7 und 8 zeigen jeweils eine schematische Darstellung einer Halbleiterstruktur 100 im Schnitt, wobei Ausführungsbeispiele für unterschiedliche laterale Ausdehnungen der weiteren Dotierungsgebiete 15 gezeigt sind.

Mit der in Fig. 9 gezeigten Konfiguration kann ein Problem vermieden werden, das mit der Verwendung hochohmiger Halbleitersubstrate 14 erstmalig auftreten kann. Bei großen Potentialhüben der 'floatenden' Emittergebiete (Dotierungsgebiet 13) wie sie mit 26 und 27 in Fig. 3 gezeigt werden und die für den Betrieb erforderlich sind, kann es Probleme damit geben, dass die ausschließlich durch die niedrige Dotierung in den Lückenbereichen realisierten Potentialbarrieren für Löcherladungen zwischen zwei direkt benachbarten Emittergebieten (Dotierungsgebieten 13) soweit abgebaut werden dass Löcherladungen zwischen diesen zu fließen beginnen. Eine ganzflächige weitere Dotierungszone 15 im gesamten Pixelbereich kann das wirksam verhindern.

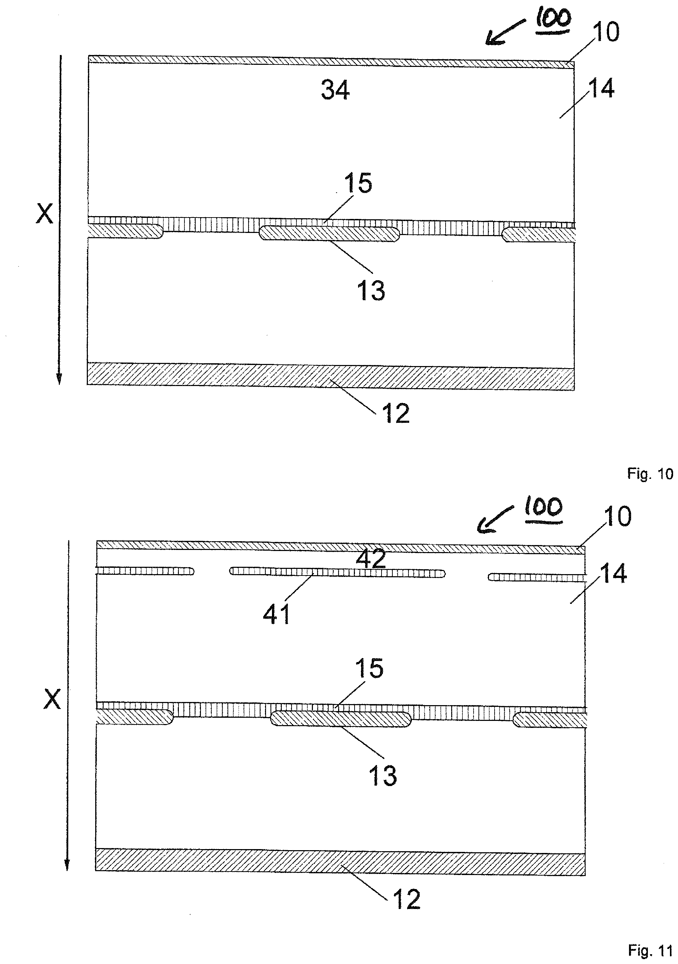

Mit der in Fig. 10 dargestellten, verschobenen Implantationstiefe der weiteren Dotierungszone 15 ist eine Arbeitspunktanpassung der Dotierungskonzentrationen möglich. Da in dem direkt oberhalb der Emittergebiete 13 liegenden Gebiet Teile der n-Typ-Dotierung der weiteren Dotierungszone 15 von der wesentlich höher konzentrierten p-Typ-Dotierung des Dotierungsgebietes 13 kompensiert werden, ist es möglich, dort eine kleinere Dotierungskonzentration als in den Lückengebieten zu realisieren. Damit wird einerseits eine ausreichende Potentialbarriere im Basisbereich eingestellt, andererseits wird die Potentialbarriere zur Trennung direkt benachbarter Emittergebiete in den Lückengebieten verstärkt.

Fig. 11 zeigt eine schematische Darstellung einer Halbleiterstruktur 100 mit zusätzlichen oberen Dotierungsgebieten 41. Mit Hilfe der zusätzlichen oberen Dotierungsgebiete 41 ist der Bereich hoher Feldstärke (Hochfeld, Avalanch-Bereich) auf ein Gebiet 42 unterhalb der Deckschicht 10 begrenzt. Hierdurch sind systematisch kleinere Betriebsspannungen der Halbleiterstruktur 100 ermöglicht.

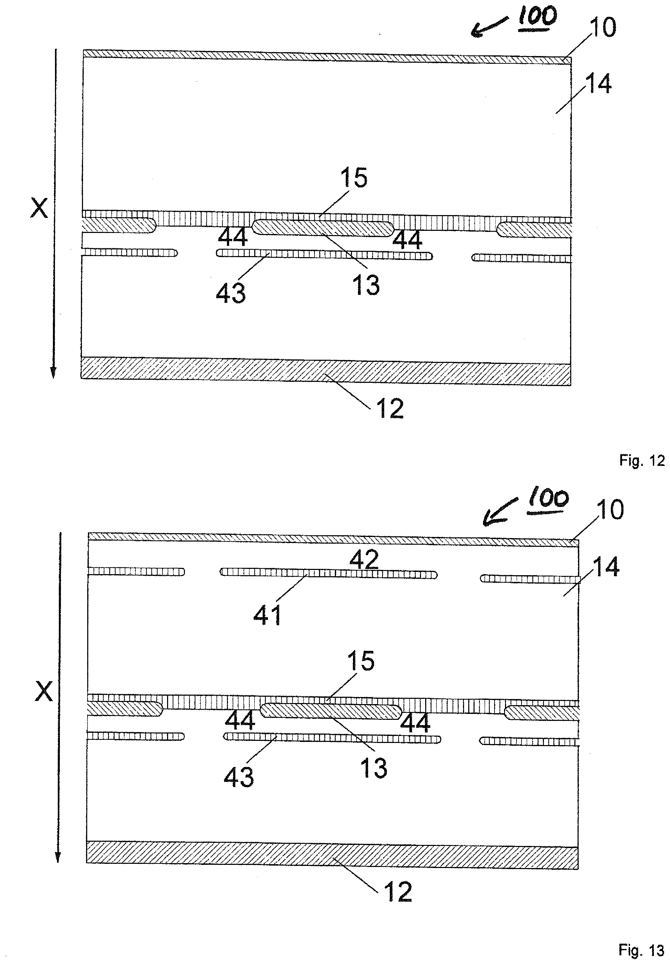

Fig. 12 zeigt eine schematische Darstellung einer Halbleiterstruktur 100 mit zusätzlichen unteren Dotierungsgebieten 43. Mit Hilfe der zusätzlichen unteren Dotierungsgebiete 43 ist der Lösch-Bereich (*"quenching"*) auf ein Gebiet 44 unterhalb der Dotierungsgebiete 13 begrenzt.

Fig. 13 zeigt eine schematische Darstellung einer Halbleiterstruktur 100 mit zusätzlichen oberen und unteren Dotierungsgebieten 41, 43. Hier wird zusätzlich die in Fig. 11 gezeigte Struktur in der Nähe der Oberfläche verwendet. So ergeben sich zwei in Serie geschaltete Avalanche-Strukturen, die über eine Bipolar-Transistor Konstruktion mit floatendem Emitter miteinander gekoppelt sind.

Insgesamt ist besteht häufig das Ziel, die Pixelgeometrien größer auszulegen, um die Probleme des *"afterpulsing"* zu begrenzen. Dazu sind kleinere Strukturkapazitäten erforderlich. Werden jedoch die zu verarmenden Gesamtschichtdicken zwischen Deckschicht 10 und Substrat 12 recht groß, kann es Probleme dergestalt geben, dass das zum Rückstellen des Potentials der Emitter erforderliche Avalanche-Feld im unteren Teil der Struktur nur schwer erreicht wird. Deshalb kann auch hier der Avalanche-Bereich vermittels der n-Typ-Dotierungszone 43 auf die mit 44 gekennzeichneten Gebiete beschränkt werden. Die gesamte erforderliche Arbeitspunktspannung wird damit weiter gesenkt.

Abschließend sei noch der zweite mögliche und vermutlich auch in der Praxis oft auftretende Fall des passiven Löschens (*"quenching"*) einer solchen Struktur erläutert.

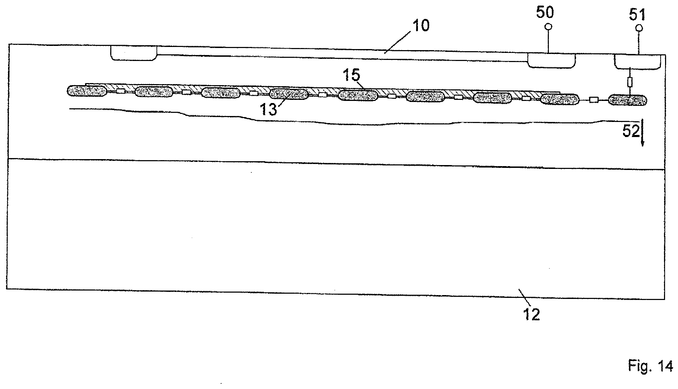

Dieser Fall tritt immer genau dann auf, wenn das elektrische Feld unterhalb der der Dotierungsgebiete 13 nicht stark genug werden kann um dort einen Avalanche-Durchbruch zu erreichen. Das ist aus geometrischen Gründen möglich, wenn zum Beispiel der Abstand zwischen 'floatendem' Dotierungsgebieten 13 und der mittels des Substrates 12 gebildeten unteren Gegenelektrode recht groß wird. In diesem Fall können die Potentialdifferenzen zwischen benachbarten floatenden Gebieten so groß werden, dass ein Ladungsträgerstrom, in diesem Fall von Löchern, zwischen ihnen einsetzt. Der oder die damit verbundenen MOS Volumenkanäle mit Ladungsträgern sind stets nahezu im Abschnürbereich und damit insgesamt recht hochohmig. Das ist deshalb in Fig. 14 symbolisch mit Widerständen allerdings hier nur in einer Dimension gekennzeichnet. Die 'floatenden' Gebiete bilden hier eine flächige zweidimensionale Matrix oder im hexagonalen Fall ein Netz aus, bei dem jeweils alle benachbarten Pixelstrukturen hochohmig miteinander gekoppelt sind.

Hierbei kommt es natürlicherweise dazu, dass die in der Mitte eines Detektors liegenden Strukturen ein anderes Arbeitspunktpotential 52 ausbilden, als die in den Randbereichen liegenden wie in Fig. 14 gezeigt. Zumal man per Layout im Randbereich dafür sorgen kann, dass die äußeren Pixel auf einem bestimmten Potentialniveau verbleiben, Arbeitspunktanschluss 51. Diese Art des Löschens ist natürlich auf Grund seiner passiven Natur und der Hochohmigkeit der Verbindungen sehr viel langsamer als die oben beschriebene aktive Struktur mit Bipolartransistor.

Außerdem kann vorgesehen sein, dass im zentralen Bereich der Struktur das Potential groß genug ist, um den Avalanche-Effekt der D2 Diode zum Rückstellen nutzen zu können, und in den Randbereichen des gleichen Detektors auf Grund der hochohmigen Koppelung der Löcherladungen an die Randbereiche nicht. Dort werden nämlich kaum die dazu erforderlichen hohen Potentiale erreicht. Damit mischen sich hier natürlich die sehr schnellen Zeiten des aktiven Rückstellens im Zentrumsbereich und die deutlich langsameren aus den Randbereichen zusammen.

Es wurde ein neuartiger Halbleiterdetektor vorgestellt, der die Koppelung von Avalanche-Bereichen mit der Konstruktion eines Bipolartransistors beschreibt. Hierdurch wird ein sehr schnelles aktives "quenching" in jedem einzelnen Pixel erreicht.

Die in der vorstehenden Beschreibung, der Zeichnung und den Ansprüchen offenbarten Merkmale der Erfindung können sowohl einzeln als auch in beliebiger Kombination für die Verwirklichung der Erfindung in ihren verschiedenen Ausführungen von Bedeutung sein.

### Bezugszeichen

- 1: Epitaxiesubstrat
- 2: Halbleitersubstrat auf dem Epitaxiesubstrat 1
- 3: Deckschicht auf Halbleitersubstrat 2
- 4: Dotierungszone des Halbleitersubstrates 2
- 10: Deckschicht auf Halbleitersubstrat 14
- 12: Substrat
- 13: Dotierungszone / -gebiet im Halbleitersubstrat 14
- 14: Halbleitersubstrat auf Substrat 12
- 15: weitere Dotierungszone / -gebiet im Halbleitersubstrat 14
- 16: Potentialverlaufskurve im thermodynamischen Gleichgewicht
- 17: Potentialverlaufskurve ohne Avalanche-Durchbruch
- 18: Potentialverlaufskurve mit hoher Feldstärke im Oberflächenbereich
- 19: Potentialverlaufskurve nach einem Triggerereignis
- 20: Potentialverlaufskurve im "gequenchten" Zustand
- 21: Oberflächenpotential an der Topdiode
- 22: Oberflächenpotential an der Topdiode
- 23: Höhe der Potentialbarriere im Basisbereich
- 24: Höhe der Potentialbarriere im Basisbereich mit gespeicherten Elektronenladungen
- 25: Höhe der Potentialbarriere im Basisbereich einer vollständig "gequenchten" Struktur
- 26: Potentialhub des Emittergebietes hervorgerufen durch Löcherabfluss
- 27: Potentialhub des Emittergebietes hervorgerufen durch gespeicherte Elektronenladungen
- 28: Transportrichtung von Löcherladungen und Position höchster Feldstärke
- 29: Transportrichtung von Elektronenladungen und Position höchster Feldstärke
- 30: Transportrichtung von Löcherladungen und Position höchster Feldstärke
- 31: Transportrichtung von Elektronenladungen und Position höchster Feldstärke
- 32: Transportrichtung von Elektronenladungen seitlich am Emittergebiet vorbei
- 33: Bereich elektrischer Feldstärke unterhalb des Avalanche-Durchbruchs
- 34: Kollektorlaufzone
- 35: Transportrichtung von Elektronenladungen seitlich am Emittergebiet vorbei
- 36: Transportrichtung von Elektronenladungen in das Emittergebiet hinein
- 37: niedrigstes Potential des Emittergebietes
- 38: mittleres Potential des Emittergebietes
- 39: höchstes Potential des Emittergebietes
- 40: Transportrichtung von Löcherladungen aus dem Emittergebiet in das Kollektorlaufgebiet hinein
- 41: zusätzliche obere Dotierungszone im Halbleitersubstrat 14
- 42: eingeschränkter Bereich der Avalanche-Feldstärke im Halbleitersubstrat 14
- 43: zusätzliche untere Dotierungszone im Halbleitersubstrat 14
- 44: eingeschränkter Bereich der Avalanche-Feldstärke im Halbleitersubstrat 14
- 45: Anlaufzeitbereich
- 46: Bipolarverstärkung, Zeitbereich
- 47: Avalanche *"quenching"* Zeitbereich
- 48: Strukturrrücksetzzeitbereich
- 49: Arbeitspunktwiderherstellung Zeitbereich
- 50: Anschluss der Topdiode
- 51: Anschluss für Arbeitspunkteinstellung, passives *"quenching"*
- 52: Potentialverlustkurve der 'floatenden' Gebiete
- 100: Halbleiterstruktur

## Patentansprüche

1. Halbleiterstruktur für einen Strahlungsdetektor, mit:
- einem Substrat (12) aus einem Halbleitermaterial von einem ersten Leitfähigkeitstyp,
- einem Halbleitersubstrat (14), wobei das Halbleitersubstrat (14)
- eine auf dem Substrat (12) angeordnete Halbleiterschicht aufweist, die im Vergleich zum Substrat (12) höherohmig ist,
- vom ersten Leitfähigkeitstyp ist und
- mit einer Dotierungskonzentration elektrisch dotiert ist,
- Dotierungsgebieten (13), wobei die Dotierungsgebiete (13)
- in dem Halbleitersubstrat (14) vergraben und isoliert voneinander gebildet sind,
- von einem zweiten Leitfähigkeitstyp sind, der entgegengesetzt zum ersten Leitfähigkeitstyp ist, und
- mit einer Dotierungskonzentration elektrisch dotiert sind, die größer als die Dotierungskonzentration in dem Halbleitersubstrat (14) ist,
- zumindest einem weiteren Dotierungsgebiet (15), wobei das zumindest eine weitere Dotierungsgebiet (15)
- in dem Halbleitersubstrat (14) vergraben und einem oder mehreren der Dotierungsgebiete (13) zugeordnet ist, derart, dass in Draufsicht auf die Fläche, in welcher sich das Halbleitersubstrat (14) erstreckt, eine vollflächige Überlappung des zumindest einen weiteren Dotierungsgebiets (15) und des zugeordneten Dotierungsgebiets gebildet ist,
- vom ersten Leitfähigkeitstyp ist und
- mit einer Dotierungskonzentration elektrisch dotiert ist, die größer als die Dotierungskonzentration in dem Halbleitersubstrat (14) ist, und
- einer Deckschicht (10), die auf dem Halbleitersubstrat (14) angeordnet und vom zweiten Leitfähigkeitstyp ist,
wobei in dem Halbleitersubstrat (14) zwischen den hierin angeordneten Dotierungsgebieten (13, 15) und der auf dem Halbleitersubstrat (14) angeordneten Deckschicht (10) ein Avalanche-Bereich gebildet ist, also ein Bereich hoher elektrischer Feldstärke, in welchem im Betrieb aufgrund von Stößen eine Vervielfältigung von freien Ladungsträgern stattfindet, und
wobei in dem Halbleitersubstrat (14) zwischen den hierin angeordneten Dotierungsgebieten (13, 15) und dem Substrat (12) ein Lösch-Bereich gebildet ist.

2. Halbleiterstruktur nach Anspruch 1, **dadurch gekennzeichnet, dass** das zumindest eine weitere Dotierungsgebiet (15) auf einer der Deckschicht (10) zugewandten Seite und / oder einer dem Substrat (12) zugewandten Seite der Dotierungsgebiete (13) gebildet ist.

3. Halbleiterstruktur nach Anspruch 1 oder 2, **dadurch gekennzeichnet, dass** das zumindest eine weitere Dotierungsgebiet (15) in Berührungskontakt mit dem oder den zugeordneten Dotierungsgebieten (13) gebildet ist.

4. Halbleiterstruktur nach mindestens einem der vorangehenden Ansprüche, **dadurch gekennzeichnet, dass** das zumindest eine weitere Dotierungsgebiet (15) in einem Überlappungsbereich, in welchem das zumindest eine weitere Dotierungsgebiet (15) überlappend mit dem oder den zugeordneten Dotierungsgebieten (13) gebildet ist, eine Schichtdicke aufweist, die von einer Schichtdicke des zumindest einen weiteren Dotierungsgebietes (15) außerhalb des Überlappungsbereiches verschieden ist.

5. Halbleiterstruktur nach Anspruch 4, **dadurch gekennzeichnet, dass** für das zumindest eine weitere Dotierungsgebiet (15) die Schichtdicke im Überlappungsbereich geringer als außerhalb des Überlappungsbereiches ist.

6. Halbleiterstruktur nach mindestens einem der vorangehenden Ansprüche, **dadurch gekennzeichnet, dass** das zumindest eine weitere Dotierungsgebiet (15) als ein zusammenhängendes Dotierungsgebiet für mehrere der Dotierungsgebiete (13) gebildet ist.

7. Halbleiterstruktur nach mindestens einem der vorangehenden Ansprüche, **dadurch gekennzeichnet, dass** das zumindest eine weitere Dotierungsgebiet (15) mit einem der Dotierungsgebiete (13) flächig überlappt und um die Überlappungsfläche ein im Wesentlichen umlaufend gleichbleibender Überstand gebildet ist, in welchem das zumindest eine weitere Dotierungsgebiet (15) gegenüber dem einen der Dotierungsgebiete (13) seitlich übersteht.

8. Halbleiterstruktur nach mindestens einem der vorangehenden Ansprüchen, **dadurch gekennzeichnet, dass** das zumindest eine weitere Dotierungsgebiet (15) zumindest abschnittsweise mit gleicher Schichtdicke wie das oder die zugeordneten Dotierungsgebiete (13) gebildet ist.

9. Halbleiterstruktur nach mindestens einem der vorangehenden Ansprüche, **dadurch gekennzeichnet, dass** das in einem Bereich des Halbleitersubstrates (14) zwischen der Deckschicht (10) und den Dotierungsgebieten (13, 15) ein oder mehrere zusätzliche obere Dotierungsgebiete (41) gebildet sind, die in dem Halbleitersubstrat (14) den Avalanche-Bereich (42) in seiner Ausdehnung von der Deckschicht (10) weg hin zu den Dotierungsgebieten (13, 15) begrenzen.

10. Halbleiterstruktur nach mindestens einem der vorangehenden Ansprüche, **dadurch gekennzeichnet, dass** in einem Bereich des Halbleitersubstrates (14) zwischen dem Substrat (12) und den Dotierungsgebieten (13, 15) ein oder mehrere zusätzliche untere Dotierungsgebiete (43) gebildet sind, die in dem Halbleitersubstrat (14) den Lösch-Bereich (44) in seiner Ausdehnung von den Dotierungsgebieten (13, 15) weg hin zum Substrat (12) begrenzen.

11. Halbleiterstruktur nach mindestens einem der vorangehenden Ansprüche, **dadurch gekennzeichnet, dass** das Halbleitersubstrat (14) hochohmig ausgeführt ist mit einem spezifischen Widerstand von wenigstens 500 Ohm cm.

12. Strahlungsdetektor, insbesondere Avalanche-Strahlungsdetektor, mit einer Halbleiterstruktur nach mindestens einem der vorangehenden Ansprüche.

## Claims

1. A semiconductor structure for a radiation detector, having:
- a substrate (12) made from a semiconductor material of a first conductivity type,
- a semiconductor substrate (14), wherein the semiconductor substrate (14)
- has a semiconductor layer arranged on the substrate (12), which is more highly resistive compared to the substrate (12),
- is of the first conductivity type, and
- is electrically doped with a doping concentration,
- doping regions (13), wherein the doping regions (13)
- are buried in the semiconductor substrate (14) and formed to be insulated from one another,
- are of a second conductivity type, which is opposite to the first conductivity type, and
- are electrically doped with a doping concentration which is greater than the doping concentration in the semiconductor substrate (14),
- at least one further doping region (15), wherein the at least one further doping region (15)
- is buried in the semiconductor substrate (14) and assigned to one or more of the doping regions (13) in such a manner that, in a plan view onto the surface, in which the semiconductor substrate (14) extends, a whole-surface overlap of the at least one further doping region (15) and the assigned doping region is formed,
- is of the first conductivity type, and
- is electrically doped with a doping concentration which is greater than the doping concentration in the semiconductor substrate (14), and
- a top layer (10), which is arranged on the semiconductor substrate (14) and is of the second conductivity type,
wherein an avalanche region is formed in the semiconductor substrate (14) between the doping regions (13, 15) arranged herein and the top layer (10) arranged on the semiconductor substrate (14), that is to say a region of high field strength, in which, during operation, a multiplication of free charge carriers takes place owing to collisions, and
wherein a quenching region is formed in the semiconductor substrate (14) between the doping regions (13, 15) arranged herein and the substrate (12).

2. The semiconductor structure according to claim 1, **characterized in that** at least one further doping region (15) is formed on a side of the doping regions (13) facing the top layer (10) and/or a side of the doping regions facing the substrate (12).

3. The semiconductor structure according to claim 1 or 2, **characterized in that** the at least one further doping region (15) is formed in touch contact with the assigned doping region(s) (13).

4. The semiconductor structure according to at least one of the preceding claims, **characterized in that** the at least one further doping region (15) has a layer thickness in an overlap region, in which the at least one further doping region (15) is formed overlapping with the assigned doping region(s) (13), which is different from a layer thickness of the at least one further doping region (15) outside the overlap region.

5. The semiconductor structure according to claim 4, **characterized in that**, for the at least one further doping region (15), the layer thickness in the overlap region is less than outside the overlap region.

6. The semiconductor structure according to at least one of the preceding claims, **characterized in that** the at least one further doping region (15) is formed as a contiguous doping region for a plurality of the doping regions (13).

7. The semiconductor structure according to at least one of the preceding claims, **characterized in that** the at least one further doping region (15) overlaps areally with one of the doping regions (13) and a substantially circumferentially uniform protrusion is formed around the overlap area, in which the at least one further doping region (15) protrudes laterally with respect to the one of the doping regions (13).

8. The semiconductor structure according to at least one of the preceding claims, **characterized in that** the at least one further doping region (15) is formed, at least in certain sections, with the same layer thickness as the assigned doping region(s) (13).

9. The semiconductor structure according to at least one of the preceding claims, **characterized in that** one or more additional upper doping regions are formed in a region of the semiconductor substrate (14) between the top layer (10) and the doping regions (13, 15), which additional upper doping regions delimit the avalanche region (42), in its extent away from the top layer (10) towards the doping regions (13, 15), in the semiconductor substrate (14).

10. The semiconductor structure according to at least one of the preceding claims, **characterized in that** one or more additional lower doping regions (43) are formed in a region of the semiconductor substrate (14) between the substrate (12) and the doping regions (13, 15), which additional upper doping regions delimit the quenching region (44), in its extent away from the doping regions (13, 15) towards the substrate (12), in the semiconductor substrate (14).

11. The semiconductor structure according to at least one of the preceding claims, **characterized in that** the semiconductor substrate (14) is designed to be highly resistive, having a specific resistance of at least 500 ohm cm.

12. A semiconductor structure, particularly avalanche radiation detector, having a semiconductor structure according to at least one of the preceding claims.

## Revendications

1. Structure semi-conductrice pour un détecteur de rayonnement, comportant:
- un substrat (12) fait d'un matériau semi-conducteur d'un premier type de conductivité,
- un substrat semi-conducteur (14), dans lequel le substrat semi-conducteur (14) présente
- une couche semi-conductrice disposée sur le substrat (12) qui, par rapport au substrat (12), a une résistance plus élevée,
- est du premier type de conductivité et
- est dopé électriquement avec une concentration de dopage
- des régions de dopage (13), dans lequel les régions de dopage (13)
- sont enterrées dans le substrat semi-conducteur (14) et formées isolées les unes des autres,
- sont d'un deuxième type de conductivité qui est opposé au premier type de conductivité, et
- sont dopées électriquement avec une concentration de dopage qui est supérieure à la concentration de dopage dans le substrat semi-conducteur (14),
- au moins une autre région de dopage (15), dans lequel la au moins une autre région de dopage (15)
- est enterrée dans le substrat semi-conducteur (14) et affectée à une ou plusieurs des régions de dopage (13) de telle sorte que, dans une vue en plan de la région dans laquelle s'étend le substrat semi-conducteur (14), un chevauchement complet de la région d'au moins une autre région de dopage (15) et du dopage attribué une région est formée,
- est du premier type de conductivité et
- est dopée électriquement avec une concentration de dopage qui est supérieure à la concentration de dopage dans le substrat semi-conducteur (14), et
- une couche de recouvrement (10), qui est disposée sur le substrat semi-conducteur (14) et est du deuxième type de conductivité,
dans lequel dans le substrat semi-conducteur (14) entre les régions de dopage disposées à l'intérieur (13, 15) et la couche de recouvrement (10) disposée sur le substrat semi-conducteur (14), une région d'avalanche est formée, c'est-à-dire une région d'intensité de champ électrique élevé, dans laquelle une duplication des supports de charge gratuits a lieu pendant l'exploitation en raison des impacts et
dans laquelle une région d'effacement est formée dans le substrat semi-conducteur (14) entre les régions de dopage (13, 15) disposées à l'intérieur et le substrat (12).

2. Structure semi-conductrice selon la revendication 1, **caractérisée en ce que** la au moins une autre région de dopage (15) est formée d'un côté des régions de dopage (13) faisant face à la couche de recouvrement (10) et/ou d'un côté des régions de dopage faisant face au substrat (12).

3. Structure semi-conductrice selon la revendication 1 ou 2, **caractérisée en ce que** la au moins une autre région de dopage (15) est formée en contact physique avec la ou les régions de dopage (13) qui lui sont affectées.

4. Structure semi-conductrice selon au moins une des revendications précédentes, **caractérisée en ce que** la au moins une autre région de dopage (15) dans une région de chevauchement dans laquelle au moins une autre région de dopage (15) est formée en se superposant à la ou les régions de dopage (13) associées présente une épaisseur de couche qui est différente de l'épaisseur de couche de la au moins une autre région de dopage (15) en dehors de la région de chevauchement.

5. Structure semi-conductrice selon la revendication 4, **caractérisée en ce que** pour la au moins une autre région de dopage (15) l'épaisseur de couche dans la région de chevauchement est inférieure à celle de l'extérieur de la région de chevauchement.

6. Structure semi-conductrice selon au moins une des revendications précédentes, **caractérisée en ce que** la au moins une autre région de dopage (15) est formée comme une région de dopage cohérente pour plusieurs des régions de dopage (13).

7. Structure semi-conductrice selon au moins une des revendications précédentes, **caractérisée en ce que** la au moins une autre région de dopage (15) chevauche exactement une des régions de dopage (13) et un surplomb sensiblement circonférentiellement constant est formé autour de la région de chevauchement, dans laquelle la au moins une autre région de dopage (15) fait saillie latéralement par rapport à laquelle l'une des régions de dopage (13).

8. Structure semi-conductrice selon au moins une des revendications précédentes, **caractérisée en ce que** la au moins une autre région de dopage (15) est formée au moins en sections de même épaisseur de couche que la ou les régions de dopage associées (13).

9. Structure semi-conductrice selon au moins une des revendications précédentes, **caractérisée en ce que** une ou plusieurs régions de dopage supérieures supplémentaires sont formées dans une région du substrat semi-conducteur (14) entre la couche de couverture (10) et les régions de dopage (13, 15), qui limitent la région d'avalanche (42) dans son extension dans le substrat semi-conducteur (14) à l'écart de la couche de couverture (10) vers les régions de dopage (13, 15).

10. Structure semi-conductrice selon au moins une des revendications précédentes, **caractérisée en ce que** dans une région du substrat semi-conducteur (14) entre le substrat (12) et les régions de dopage (13, 15) une ou plusieurs régions de dopage inférieures supplémentaires (43) sont formées qui, dans le substrat semi-conducteur (14), limitent la région d'effacement (44) dans son extension à l'écart des régions de dopage (13, 15) vers le substrat (12).

11. Structure semi-conductrice selon au moins une des revendications précédentes, **caractérisée en ce que** le substrat semi-conducteur (14) présente une résistance élevée avec une résistance spécifique d'au moins 500 ohm cm.

12. Détecteur de rayonnement, en particulier détecteur de rayonnement d'avalanche, comportant une structure semi-conductrice selon au moins une des revendications précédentes.
